# FASCICULE DE BREVET EUROPEEN

(11) **EP 0 803 949 B1**
(45) Date de publication et mention de la délivrance du brevet: **05.09.2001**
(21) Numéro de dépôt: 97400861.7
(22) Date de dépôt: 17.04.1997
(51) Int. Cl.: H01S 5/40, H01S 5/024, H01S 5/02, H01S 5/10

(54) **Dispositif laser à diodes**
Diodenlaservorrichtung
Laser diode device

(30) Priorité: 23.04.1996 RU 96108180
(43) Date de publication de la demande: 29.10.1997
(73) Titulaire: COMPAGNIE INDUSTRIELLE DES LASERS CILAS, F-91460 Marcoussis (FR)
(72) Inventeur: Apollonov, Victor Victorovich, 117333 Moscou (RU); Babayants, Gennadiy Ivanovich, 142100 Podolsk, Moscou (US); Derjavin, Sergey Igorevich, 125502 Moscou (US); Kishmakhov, Batory Shakhimovich, 142117 Podolsk, Moscou (US); Koval, Yury Petrovich, 140070 Tomilino Moscou (RU); Kuzminov, Vitaliy Vladimirovich, 129278 Moscou (RU); Mashkovsky, Dmitry Alecsandrovich, 117463 Moscou (RU); Prokhorov, Alexandr Mikhaylovich, 117831 Moscou (RU); Smekalin, Victor Pavlovich, 113535 Moscou (US); Cornillault, Jean, 91620 Nozay (FR)
(74) Mandataire: Bonnetat, Christian

(56) Documents cités:
- EP-A- 0 439 227
- GB-A- 1 597 707
- US-A- 5 128 951
- ENDRIZ J G ET AL: "HIGH POWER DIODE LASER ARRAYS" IEEE JOURNAL OF QUANTUM ELECTRONICS, vol. 28, no. 4, 1 avril 1992, pages 952-965, XP000272686

## Description

La présente invention concerne un dispositif laser à diodes, dans lequel lesdites diodes sont agencées dans une pluralité de barrettes semi-conductrices, disposées parallèlement les unes aux autres et fixées sur un substrat diffuseur de la chaleur, lui-même relié à un système de refroidissement. Les diodes laser sont obtenues par épitaxie sur des substrats semi-conducteurs, qui sont découpés en bandes pour former lesdites barrettes de diodes laser. Un tel dispositif laser à diodes est par exemple décrit :
- dans I.E.E.E Journal of Quantum Electronics, Vol.28, No.4, Avril 1992, pages 952 à 965 "High Power Diode Laser Arrays" et pages 966 à 976 "Modular Microchannel Cooled Heatsinks for High Average Power Laser Diode Arrays ; et
- dans le brevet américain N°5 128 951.

Les applications des dispositifs laser à diodes sont nombreuses, comme par exemple le pompage des lasers à solides (voir le brevet américain N°4 847 851), les liaisons par fibres optiques, le traitement laser des matériaux, la médecine, etc...

Les dispositifs laser à diodes actuellement connus et décrits dans l'art antérieur ci-dessus sont essentiellement de deux types.

Dans le premier type, les barrettes semi-conductrices sont soudées à plat sur une face du substrat diffuseur de la chaleur et cette face est usinée pour présenter, entre deux barrettes semi-conductrices adjacentes, des miroirs susceptibles de réfléchir les rayonnements émis par lesdites diodes, à l'opposé de ladite face. Dans un tel mode de réalisation, la chaleur est extraite de façon efficace desdites diodes, de sorte que celles-ci ont un fonctionnement fiable. En revanche, on ne peut ainsi obtenir un rayonnement suffisamment dense et uniforme.

Dans le second type de dispositifs connus, on prévoit dans une face du substrat diffuseur de la chaleur un système de nervures et de rainures parallèles à sections rectangulaires, lesdites rainures formant des logements dans lesquels lesdites barrettes semi-conductrices sont disposées longitudinalement de chant. Une telle disposition permet d'augmenter la densité des barrettes semi-conductrices sur le substrat diffuseur, mais elle ne peut assurer l'obtention d'une grande densité de rayonnement, car l'évacuation de chaleur est trop faible, du fait de la faible surface de contact. Les diodes laser sont donc surchauffées et rapidement détruites, si on recherche une densité de rayonnement élevée.

La présente invention a pour objet de remédier à ces inconvénients, en augmentant la densité et l'uniformité du rayonnement d'un dispositif laser à diodes. Elle permet d'augmenter les échanges thermiques entre les barrettes et le substrat diffuseur de chaleur ainsi que la durée de vie desdites diodes, tout en simplifiant les connexions électriques des barrettes semi-conductrices et en permettant d'automatiser la production dudit dispositif et donc d'en réduire les coûts de fabrication.

A cette fin, selon l'invention, le dispositif laser à diodes comportant :
- un substrat diffuseur de chaleur en une matière bonne conductrice de la chaleur, dans une face duquel est réalisé un système de nervures et de rainures parallèles, lesdites nervures étant identiques et équidistantes ; et
- une pluralité de barrettes semi-conductrices incorporant lesdites diodes et logées longitudinalement dans lesdites rainures,
est remarquable en ce que lesdites nervures présentent une section au moins approximativement en forme d'un triangle relié audit substrat par l'un de ses côtés et en ce que chaque barrette semi-conductrice est fixée à plat sur un flanc oblique d'une desdites nervures. On remarquera que, dans cette disposition, chaque rainure est délimitée entre deux flancs obliques divergents appartenant aux deux nervures situées de part et d'autre de ladite rainure.

Par ailleurs, avantageusement, les deux flancs obliques de chaque nervure font entre eux un angle dièdre au moins approximativement égal à l'angle de divergence desdites diodes laser, par exemple de l'ordre de 60°.

Ainsi, puisque les diodes laser sont disposées au voisinage de la surface refroidissante sur la base massive des nervures triangulaires, on assure une bonne évacuation de la chaleur des jonctions des diodes laser. De plus, les flux lumineux issus desdites diodes ainsi disposées en oblique se recouvrent, ce qui permet d'augmenter la densité et l'uniformité du rayonnement résultant. On obtient ainsi un compromis raisonnable en ce qui concerne la densité de couverture de la surface du substrat diffuseur par les barrettes semi-conductrices.

Afin de former des connexions entre lesdites diodes, ledit système de nervures et de rainures parallèles est revêtu d'un film de métallisation sur lequel sont fixées à plat lesdites barrettes semi-conductrices et ledit film de métallisation comporte des bandes d'interruption parallèles auxdites nervures et rainures.

De telles bandes d'interruption sont avantageusement obtenues par destruction volontaire du film de métallisation, initialement uniforme, en des endroits particuliers, par exemple à l'aplomb des sommets des nervures ou à l'aplomb des fonds des rainures.

De préférence, afin de parfaire le lissage de la surface du substrat et l'isolation électrique entre les diodes laser et ledit substrat, on prévoit, entre ledit système de nervures et de rainures et ledit film de métallisation, un film d'une matière conductrice de la chaleur, mais non conductrice de l'électricité.

Selon un premier mode de réalisation de l'invention :
- dans chaque rainure, on dispose deux barrettes semi-conductrices fixées à plat sur les flancs obliques divergents en regard de ladite rainure ;
- lesdites barrettes semi-conductrices sont du même type de conduction ;
- les bandes d'interruption du film de métallisation se trouvent à l'aplomb des sommets desdites nervures ;
- dans chaque rainure, un premier conducteur relie électriquement entre elles les deux barrettes semi-conductrices ; et
- des seconds conducteurs relient, à chaque fois, le premier conducteur d'une rainure à la partie du film de métallisation se trouvant dans la rainure adjacente.

Grâce à une telle disposition, les deux barrettes semi-conductri ces d'une rainure sont montées en parallèle et les montages parallèles des deux barrettes de toutes les rainures sont reliés en série.

Dans une variante de réalisation de l'invention, on peut prévoir que :
- dans chaque rainure, on dispose une seule barrette semi-conductrice, de façon que toutes les barrettes semi-conductrices du dispositif soient fixées à plat sur des flancs obliques parallèles ;
- les barrettes semi-conductrices sont du même type de conduction ;
- les bandes d'interruption du film de métallisation se trouvent à l'aplomb des fonds desdites rainures ; et
- un conducteur relie électriquement, dans chaque rainure, la barrette semi-conductrice qui s'y trouve à la partie de film de métallisation recouvrant le flanc oblique opposé au flanc oblique sur lequel est fixée ladite barrette semi-conductrice.

Dans un tel dispositif, toutes les barrettes semi-conductrices sont montées en série. L'intensité du rayonnement est quelque peu diminuée par rapport au premier mode de réalisation du fait que le nombre de barrettes semi-conductrices est divisé par deux, mais les connexions électriques sont encore plus simplifiées.

Dans encore une autre variante de réalisation de l'invention :
- dans chaque rainure, on dispose deux barrettes semi-conductrices fixées à plat sur les flancs obliques divergents délimitant ladite rainure ;
- les deux barrettes semi-conductrices d'une rainure sont de types de conduction opposés et toutes les barrettes semi-conductrices d'un type de conduction sont fixées sur des flancs obliques parallèles ;
- les bandes d'interruption du film de métallisation se trouvent à l'aplomb des fonds desdites rainures ; et
- dans chaque rainure, un conducteur relie entre elles les deux barrettes semi-conductrices de types de conduction opposés.

On obtient ainsi le montage en série de toutes les barrettes semi-conductrices, sans autres connexions que celles résultant du film de métallisation et desdits conducteurs mentionnés ci-dessus en dernier lieu.

On notera que, dans les trois modes de réalisation décrits ci-dessus, la structure nécessite peu de connexions, de sorte que le schéma de connexion est simple et que la fabrication peut être facilement automatisée.

Les figures du dessin annexé feront bien comprendre comment l'invention peut être réalisée. Sur ces figures, des références identiques désignent des éléments semblables.

La figure 1 montre, en perspective, le substrat diffuseur de chaleur du dispositif laser à diodes conforme à la présente invention.

Les figures 2A, 2B et 2C illustrent un premier mode de réalisation du dispositif laser à diodes de l'invention.

Les figures 3A, 3B et 3C illustrent un deuxième mode de réalisation du dispositif laser à diodes de l'invention.

Les figures 4A, 4B et 4C illustrent un troisième mode de réalisation du dispositif laser à diodes de l'invention.

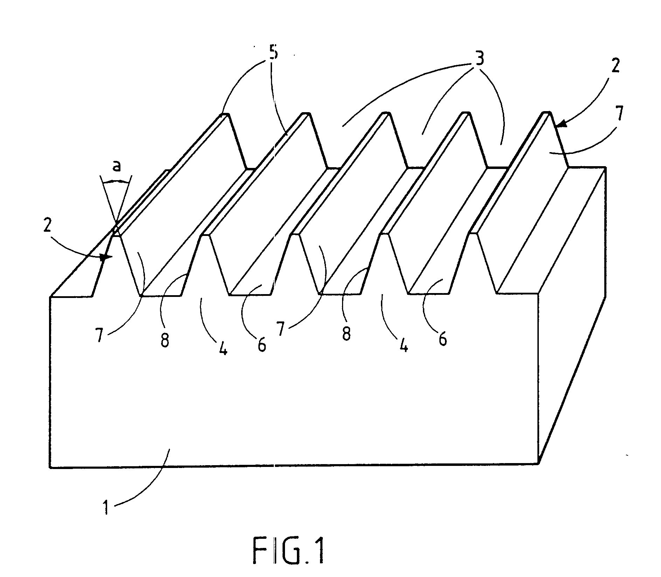

Le substrat diffuseur de chaleur 1 pour le dispositif laser à diodes de l'invention, représenté sur la figure 1, est constitué d'un bloc de forme générale parallélépipédique en une matière fortement conductrice de la chaleur, mais, de préférence, peu ou pas conductrice de l'électricité, comme le diamant, le carbure de silicium, l'oxyde de béryllium, etc.. Il est avantageux que, de plus, il soit rendu poreux ou pourvu de micro-canaux, par tout procédé connu. Les faces du substrat 1 peuvent être polies jusqu'à l'obtention de rugosités au plus égales à 3 nanomètres. Le substrat est porté par un système de refroidissement, non représenté.

Dans l'une des grandes faces du substrat 1 est réalisé un système de nervures 2 et de rainures 3 parallèles, lesdites nervures étant identiques et équidistantes. Dans l'exemple particulier représenté, ce système comporte cinq nervures 2 à section au moins approximativement triangulaire et quatre rainures 3 à section au moins approximativement trapézoïdale, chaque rainure 3 étant définie par l'espace entre deux nervures parallèles 2 adjacentes. Chaque nervure 2 est reliée au substrat 1 par une large base 4 et son sommet 5, dirigé à l'opposé dudit substrat 1, peut être coupé. Chaque rainure 3 s'ouvre à l'opposé dudit substrat 1 en s'évasant depuis son fond 6. Chaque nervure 2 comporte deux flancs plans 7 et 8, obliques et convergents, faisant entre eux un angle dièdre a. Ainsi, chaque rainure 3 est délimitée entre les flancs plans divergents 7 et 8 de deux nervures 2 adjacentes.

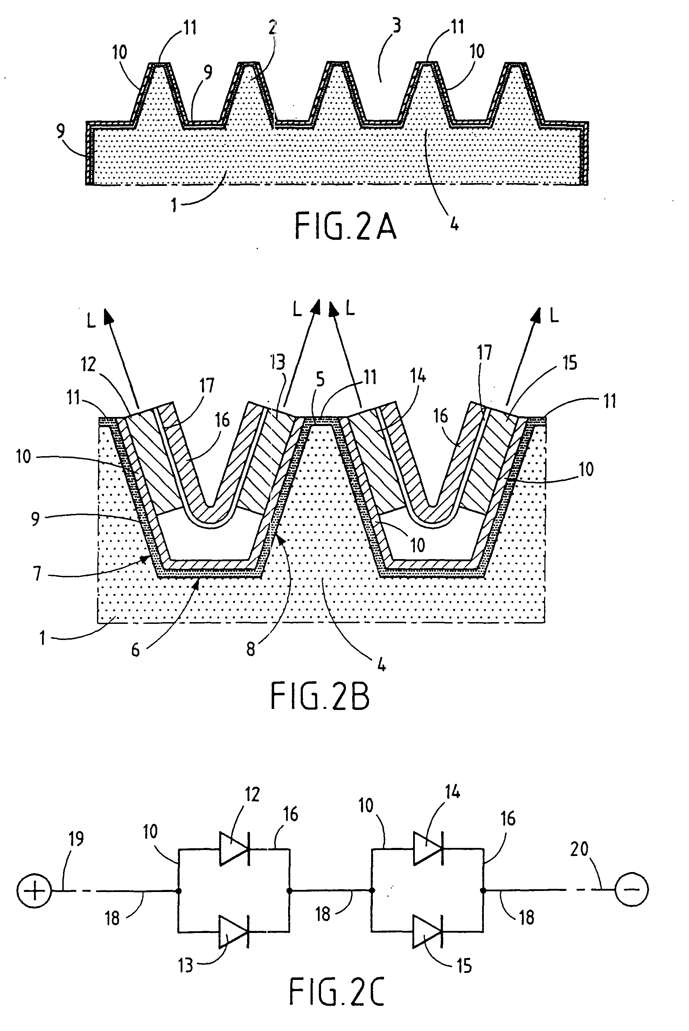

Comme l'illustrent les figures 2A, 3A et 4A, au moins la partie du substrat 1 qui porte les nervures 2 et les rainures 3 est revêtue d'un film 9 d'une matière conductrice de la chaleur, mais non conductrice de l'électricité, telle que le carbure de silicium. Le film 9 recouvre notamment les fonds 6 des rainures 3, ainsi que le sommet 5 et les flancs 7 et 8 des nervures 2. Il peut avoir une épaisseur de l'ordre de 50 à 200 microns. En plus de sa fonction de conduction thermique, le film 9 a pour objet d'accroître encore le lissage du substrat 1.

Par ailleurs, comme cela est également représenté sur les figures 2A, 3A et 4A, le film thermiquement conducteur 9 est recouvert par un film de métallisation 10, par exemple en chrome, en titane, en nickel, en or, en argent ou en un alliage de ces métaux. Le film de métallisation 10 peut avoir une épaisseur de l'ordre de 50 à 200 microns.

Dans le mode de réalisation des figures 2A, 2B et 2C, le film de métallisation 10 recouvre le film 9 à l'aplomb des fonds 6 des rainures 3 et des flancs 7 et 8 des nervures 2, mais est détruit à l'aplomb des sommets 5 de ces dernières. Ainsi, en correspondance avec lesdits sommets 5, le film 10 est interrompu selon des bandes 11 dans lesquelles apparaît le film 9.

Comme le montre la figure 2B, qui correspond à un agrandissement partiel de la figure 1 montrant deux rainures adjacentes 3 de part et d'autre d'une nervure 2, dans chacune desdites rainures 3 sont montées deux barrettes semi-conductrices portant des diodes laser. Ces barrettes semi-conductrices portent les références 12 et 13 pour l'une des rainures 3 et les références 14 et 15 pour l'autre desdites rainures. Chacune des barrettes semi-conductrices 12 à 15 est supposée être de type n et est fixée à plat du côté du substrat sur la partie du film de métallisation 10 qui recouvre soit un flanc oblique 7, soit un flanc oblique 8, par exemple par soudage à l'aide d'une soudure à basse température de fusion comme l'indium, l'étain ou l'or. Ainsi, dans chaque rainure 3 une barrette semi-conductrice 12 ou 14 est portée par le flanc oblique 7 correspondant, tandis que l'autre barrette semi-conductrice 13 ou 15 est portée par le flanc oblique 8 associé, de sorte que les deux barrettes semi-conductrices d'une rainure, 12 et 13 d'une part et 14 et 15 d'autre part, sont électriquement reliées l'une à l'autre par leurs faces de fixation, par l'intermédiaire des parties du film de métallisation 10 recouvrant le fond 6 et les flancs obliques 7 et 8. Par ailleurs, dans chaque rainure 3, une bande électriquement conductrice 16 en forme de V, par exemple métallique (cuivre) et présentant une épaisseur comprise entre 50 et 200 microns, relie électriquement les faces des barrettes semi-conductrices correspondantes 12 et 13 ou 14 et 15, opposées aux faces de fixation de ces dernières. Une couche d'accrochage thermiquement et électriquement conductrice 17 peut être prévue entre les bandes conductrices 16 et les diodes 12 à 15.

Ainsi, comme cela est illustré sur la figure 2C, la barrette semi-conductrice 12 est montée électriquement en parallèle sur la barrette semi-conductrice 13, d'une part par le film de métallisation 10 recouvrant la rainure 3 correspondante et d'autre part par la bande conductrice 16 associée. De même, la barrette semi-conductrice 14 est montée électriquement en parallèle sur la barrette semi-conductrice 15, d'une part par le film de métallisation 10 recouvrant la rainure 3 correspondante et d'autre part par la bande conductrice 16 associée. Les montages en parallèle des barrettes, 12 et 13 d'une part et 14 et 15 d'autre part, peuvent par ailleurs être montés en série par un conducteur 18 reliant la bande 16 des diodes 12 et 13 à la partie du film 10 associée aux diodes 14 et 15. Un tel conducteur 18 est montré sur la figure 2C, mais non sur la figure 2B.

De ce qui précède, on comprendra aisément que le montage parallèle-série qui vient d'être décrit pour les quatre barrettes semi-conductrices de deux rainures adjacentes s'applique à la totalité des barrettes semi-conductrices du dispositif. Aux extrémités du montage parallèle-série global, un conducteur 19 peut relier le pôle + d'une source électrique au film 10 de la première paire de barrettes en parallèle, tandis qu'un conducteur 20 peut relier la bande conductrice 16 de la dernière paire de barrettes en parallèle au pôle - de ladite source électrique.

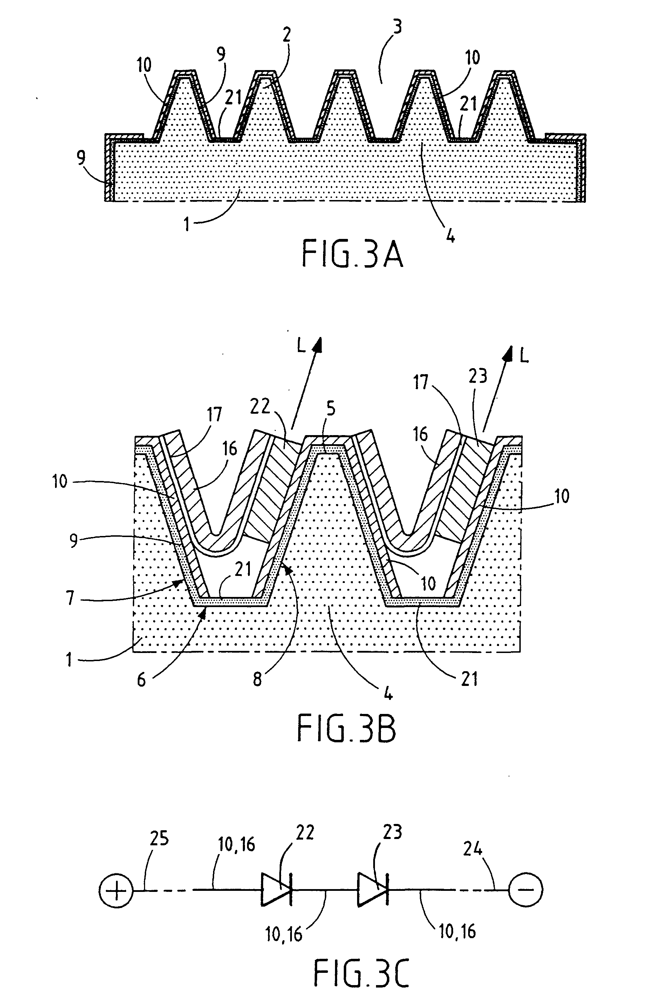

Dans le mode de réalisation des figures 3A, 3B et 3C (qui correspondent respectivement aux figures 2A, 2B et 2C), le film de métallisation 10 recouvre le film 9 à l'aplomb des sommets 5 et des flancs obliques 7 et 8 des nervures 2, mais non à l'aplomb des fonds 6 des rainures 3. Par suite, en correspondance avec lesdits fonds 6, le film 10 est interrompu selon les bandes 21 dans lesquelles apparaît le film 9.

Par ailleurs, dans ce dernier mode de réalisation, dans chacune desdites rainures 3 n'est montée qu'une seule barrette semi-conductrice portant des diodes laser. Sur la figure 3B, cette barrette porte la référence 22 pour l'une des rainures 3 et la référence 23 pour la rainure 3 adjacente. Les barrettes semi-conductrices 22 et 23 sont supposées être de type n et chacune d'elles est fixée sur la face oblique 8 de la rainure 3 dans laquelle elle se trouve, comme cela a été décrit ci-dessus à propos des barrettes 13 et 15. Dans ce mode de réalisation, chaque bande électriquement conductrice 16 en forme de V relie électriquement la face de la barrette 22 ou 23, opposée à la face de fixation de cette dernière, à la partie du film de métallisation 10 recouvrant la face oblique 7 correspondante.

Ainsi, comme cela est illustré sur la figure 3C, les deux barrettes semi-conductrices 22 et 23 sont montées en série par l'intermédiaire de la bande conductrice 16 associée à la barrette 23 et de la partie du film de métallisation 10 recouvrant la nervure 2 séparant lesdites barrettes.

Ce montage en série des deux barrettes semi-conductrices de deux rainures adjacentes peut bien entendu être généralisé à la totalité des barrettes du dispositif. Aux extrémités du montage en série complet, on prévoit des conducteurs 24 et 25 pour relier ledit montage respectivement aux pôle + et - d'une source électrique.

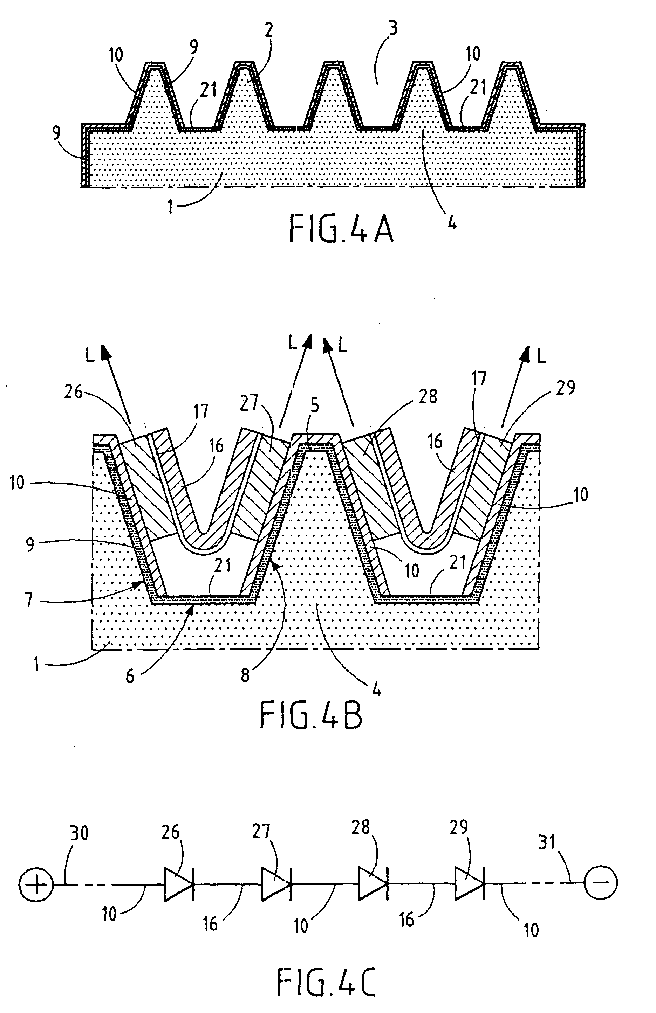

Dans le mode de réalisation des figures 4A, 4B et 4C (qui correspondent respectivement aux figures 2A, 2B et 2C), le film de métallisation 10 est semblable à celui des figures 3A,3B et 3C et comporte des bandes d'interruption 21 en concordance avec les fonds 6 des rainures 3. Par ailleurs, dans ce mode de réalisation, chaque rainure 3 comporte deux barrettes semi-conductrices 26 et 27 ou 28 et 29 respectivement, montées de manière identique aux barrettes semi-conductrices 12 et 13, ou 14 et 15 de la figure 2B. Cependant, dans ce cas, les barrettes semi-conductrices 26 et 28, montées sur les faces obliques 7, sont de type n, tandis que les barrettes semi-conductrices 27 et 29, montées sur les faces obliques 8, sont de type p.

Ainsi, comme cela est illustré sur la figure 4C, les deux barrettes 26 et 27, de types de conduction opposés, sont montées en série par la bande conductrice 16 en forme de V correspondante. Il en est de même pour les deux barrettes 28 et 29. Par ailleurs, les barrettes 27 et 28, également de types de conduction opposés, sont reliées l'une à l'autre en série par la partie du film de métallisation 10 recouvrant la nervure 2 séparant les deux rainures 3 adjacentes. Par suite, comme cela est illustré sur la figure 4C, les quatre barrettes semi-conductrices 26 à 29 sont montées en série, du fait, d'une part, de l'alternance de leur type de conduction et, d'autre part, des liaisons électriques établies alternativement par le film de métallisation 10 et par les bandes électriquement conductrices 16.

On comprendra aisément qu'un tel montage en série des quatre barrettes semi-conductrices de deux rainures 3 adjacentes peut s'étendre à la totalité des barrettes du dispositif. Aux extrémités du montage en série complet, des conducteurs 30 et 31 (voir la figure 4C) permettent de relier ledit montage respectivement aux pôles + et - d'une source électrique.

Sur les figures 2B, 3B et 4B, on a représenté le rayonnement des diodes des barrettes semi-conductrices par des flèches L. L'angle dièdre a des flancs plans obliques 7 et 8 des nervures 2 est défini par la divergence du rayonnement L des diodes laser.

Par le choix de la valeur de cet angle a, on peut obtenir un maximum d'uniformité du rayonnement à une certaine distance du dispositif. Par variation de l'angle a, on peut augmenter ou diminuer le nombre de barrettes de diodes laser par unité de surface du substrat. Les sommets 5 des nervures et les fonds 6 des rainures peuvent être aigus, plats ou arrondis. Leur aspect est déterminé par le procédé de connexion électrique des barrettes de diodes laser.

Les flancs obliques 7 et 8 des nervures 2 doivent avoir une largeur supérieure à celle d'une barrette de diodes laser (~0,5 mm). Technologiquement il est commode qu'elle soit supérieure à 0,8-1,0 mm. Si l'angle a est égal à 60° (valeur typique de l'angle de divergence du rayonnement des diodes laser), alors, sur une longueur de 1 cm, on peut disposer jusqu'à 20 réglettes de diodes laser.

L'épaisseur du film de métallisation 10 et des bandes de connexion 16 est choisie comprise entre 50 et 200 *µ*m de façon que ceux-ci puissent facilement laisser passer des courants jusqu'à 100 ampères pour des durées de 200 à 400 *µ*s.

La structure du dispositif à diodes laser selon l'invention permet de réaliser une production automatique à l'aide d'un gabarit ayant le même profil que les barrettes de diodes laser.

L'extrémité des barrettes à diodes laser dirigée vers le fond 6 des rainures 3 est avantageusement recouverte d'une couche réfléchissante à 100 %, afin que le rayonnement ne soit dirigé que vers l'extérieur.

Le substrat diffuseur de chaleur 1 est fixé (par exemple par collage) sur un système de refroidissement (non représenté) par exemple du type à circulation de fluide. De plus, ce substrat peut avoir une structure poreuse ou à micro-canaux à travers laquelle on peut faire passer un liquide de refroidissement.

On notera qu'en assemblant plusieurs dispositifs conformes à l'invention, on peut obtenir une matrice de diodes laser de n'importe quelle dimension.

## Revendications

1. Dispositif laser à diodes comportant :
- un substrat (1) diffuseur de la chaleur en une matière bonne conductrice de la chaleur, dans une face duquel est réalisé un système de nervures (2) et de rainures (3) parallèles, lesdites nervures (2) étant identiques et équidistantes, et
- une pluralité de barrettes semi-conductrices (12 à 15-22,23-26 à 29) incorporant lesdites diodes et logées longitudinalement dans lesdites rainures (3),
**caractérisé en ce que** lesdites nervures (2) présentent une section au moins approximativement en forme d'un triangle relié audit substrat (1) par l'un de ses côtés et en ce que chaque barrette semi-conductrice est fixée à plat sur un flanc oblique (7,8) d'une desdites nervures (2).

2. Dispositif selon la revendication 1,
**caractérisé en ce que** les deux flancs obliques (7,8) de chaque nervure (2) font entre eux un angle dièdre (a) au moins approximativement égal à l'angle de divergence desdites diodes laser.

3. Dispositif selon la revendication 2,
**caractérisé en ce que** ledit angle dièdre (a) est de l'ordre de 60°.

4. Dispositif selon l'une quelconque des revendications 1 à 3,
**caractérisé en ce que** ledit système de nervures (2) et de rainures (3) parallèles est revêtu d'un film de métallisation (10) sur lequel sont fixées à plat lesdites barrettes semi-conductrices et en ce que ledit film de métallisation (10) comportent des bandes d'interruption (11,21) parallèles auxdites nervures (2) et rainures (3).

5. Dispositif selon la revendication 4,
**caractérisé en ce qu**'il comporte, entre ledit système de nervures (2) et de rainures (3) et ledit film de métallisation (10), un film (9) d'une matière conductrice de la chaleur, mais non conductrice de l'électricité.

6. Dispositif selon l'une des revendications 4 ou 5,
**caractérisé en ce que** :
- dans chaque rainure (3), on dispose deux barrettes semi-conductrices (12,13 ou 14,15) fixées à plat sur les flancs obliques divergents en regard (7,8) de ladite rainure (3) ;
- lesdites barrettes semi-conductrices sont du même type de conduction ;
- les bandes d'interruption (11) du film de métallisation (10) se trouvent à l'aplomb des sommets (5) desdites nervures (2) ;
- dans chaque rainure (3) un premier conducteur (16) relie électriquement entre elles les deux barrettes semi-conductrices ; et
- des seconds conducteurs (18) relient, à chaque fois, le premier conducteur (16) d'une rainure (3) à la partie du film de métallisation (10) se trouvant dans la rainure (3) adjacente.

7. Dispositif selon l'une des revendications 4 ou 5,
**caractérisé en ce que** :
- dans chaque rainure (3), on dispose une seule barrette semi-conductrice (22,23) de façon que toutes les barrettes semi-conductrices du dispositif soient fixées à plat sur des flancs obliques (8) parallèles ;
- les barrettes semi-conductrices sont du même type de conduction ;
- les bandes d'interruption (21) du film de métallisation (10) se trouvent à l'aplomb des fonds (6) desdites rainures (3) ; et
- un conducteur (16) relie électriquement, dans chaque rainure (3), la barrette semi-conductrice qui s'y trouve à la partie de film de métallisation recouvrant le flanc oblique (7) opposé au flanc oblique (8) sur lequel est fixée ladite barrette semi-conductrice.

8. Dispositif selon l'une des revendications 4 ou 5,
**caractérisé en ce que** :
- dans chaque rainure (3), on dispose deux barrettes semi-conductrices (26, 27 ou 28,29) fixées à plat sur les flancs obliques divergents délimitant ladite rainure (3) ;
- les deux barrettes semi-conductrices d'une rainure (3) sont de types de conduction opposés et toutes les barrettes semi-conductrices d'un type de conduction sont fixées sur des flancs obliques parallèles ;
- les bandes d'interruption (21) du film de métallisation (10) se trouvent à l'aplomb des fonds (6) desdites rainures (3) ; et
- dans chaque rainure (3), un conducteur (16) relie entre elles les deux barrettes semi-conductrices de types de conduction opposés.

9. Dispositif selon l'une des revendications 4 à 8,
**caractérisé en ce que** l'épaisseur du film de métallisation (10) est comprise entre 50 et 200 microns.

10. Dispositif selon l'une des revendications 6 à 9,
**caractérisé en ce que** lesdits conducteurs (16) se présentent sous la forme de bandes dont l'épaisseur est comprise entre 50 et 200 microns.

## Patentansprüche

1. Diodenlaservorrichtung, die enthält:
- ein Wärmediffusionssubstrat (1) aus einem Material mit guter Wärmeleitfähigkeit, auf dessen einer Seite ein System aus parallelen Rippen (2) und Nuten (3) angebracht ist, wobei die genannten Rippen (2) identisch und gleich weit voneinander entfernt sind, und
- eine Vielzahl von Halbleiterstreifen (12 bis 15-22, 23-26 bis 29), die die genannten Dioden einschließen und in Längsrichtung in die genannten Nuten (3) eingebracht sind,
**dadurch gekennzeichnet**, daß die genannten Rippen (2) einen Querschnitt aufweisen, der zumindest annähernd die Form eines Dreiecks hat, das durch eine seiner Seiten mit dem genannten Substrat (1) verbunden ist, und dadurch, daß jeder Halbleiterstreifen flach auf einer schrägen Flanke (7, 8) einer der genannten Rippen (2) befestigt ist.

2. Vorrichtung nach Anspruch 1,
**dadurch gekennzeichnet**, daß die beiden schrägen Flanken (7, 8) jeder Rippe (2) einen Flächenwinkel (a) bilden, der zumindest annähernd gleich dem Divergenzwinkel der genannten Laserdioden ist.

3. Vorrichtung nach Anspruch 2,
**dadurch gekennzeichnet**, daß der genannte Flächenwinkel (a) in der Größenordnung von 60° liegt.

4. Vorrichtung nach einem beliebigen der Ansprüche 1 bis 3,
**dadurch gekennzeichnet**, daß das genannte System aus parallelen Rippen (2) und Nuten (3) mit einem Metallfilm (10) überzogen ist, auf dem flach die genannten Halbleiterstreifen befestigt sind, und dadurch, daß der genannte Metallfilm (10) Unterbrechungszonen (11, 21) aufweist, die zu den genannten Rippen (2) und Nuten (3) parallel liegen.

5. Vorrichtung nach Anspruch 4,
**dadurch gekennzeichnet**, daß sie zwischen dem genannten System aus Rippen (2) und Nuten (3) und dem genannten Metallfilm (10) einen Film (9) aus einem wärmeleitfähigen Werkstoff, der jedoch nicht elektrisch leitfähig ist, aufweist.

6. Vorrichtung nach einem der Ansprüche 4 oder 5, **dadurch gekennzeichnet**, daß
- in jede Nut (3) zwei Halbleiterstreifen (12, 13 oder 14, 15) eingebracht sind, die flach auf den gegenüberliegenden divergierenden schrägen Flanken (7, 8) der genannten Nut (3) befestigt sind;
- die genannten Halbleiterstreifen vom gleichen Leitungstyp sind;
- die Unterbrechungszonen (11) des Metallfilms (10) sich auf den Scheiteln (5) der genannten Rippen (2) befinden;
- in jeder Nut (3) ein erster Leiter (16) die beiden Halbleiterstreifen elektrisch miteinander verbindet; und
- zweite Leiter (18) jeweils den ersten Leiter (16) einer Nut (3) mit dem Teil des Metallfilms (10) verbinden, der sich in der benachbarten Nut (3) befindet.

7. Vorrichtung nach einem der Ansprüche 4 oder 5,
**dadurch gekennzeichnet**, daß
- in jeder Nut (3) ein einziger Halbleiterstreifen (22, 23) angeordnet ist, so daß alle Halbleiterstreifen der Vorrichtung flach auf parallelen schrägen Flanken (8) befestigt sind;
- die Halbleiterstreifen vom gleichen Leitungstyp sind;
- die Unterbrechungszonen (21) des Metallfilms (10) sich auf dem Boden (6) der genannten Nuten (3) befinden; und
- ein Leiter (16) in jeder Nut (3) den sich befindlichen Halbleiterstreifen, mit dem Teil des Metallfilms elektrisch verbindet, der die schräge Flanke (7) bedeckt, die
- der schrägen Flanke (8) gegenüberliegt, auf der der genannte Halbleiterstreifen befestigt ist;

8. Vorrichtung nach einem der Ansprüche 4 oder 5,
**dadurch gekennzeichnet**, daß
- in jeder Nut (3) zwei Halbleiterstreifen (26, 27 oder 28, 29) angeordnet sind, die flach auf den divergierenden schrägen Flanken befestigt sind, die die genannte Nut (3) begrenzen;
- die beiden Halbleiterstreifen einer Nut (3) entgegengesetzten Leitungstyps sind und alle Halbleiterstreifen desselben Leitungstyps auf parallelen schrägen Flanken befestigt sind;
- die Unterbrechungszonen (21) des Metallfilms (10) sich auf dem Boden (6) der genannten Nuten (3) befinden; und
- in jeder Nut (3) ein Leiter (16) die beiden Halbleiterstreifen entgegengesetzien Leitungstyps miteinander verbindet.

9. Vorrichtung nach einem der Ansprüche 4 bis 8,
**dadurch gekennzeichnet**, daß die Dicke des Metallfilms (10) zwischen 50 und 200 Mikron liegt.

10. Vorrichtung nach einem der Ansprüche 6 bis 9,
**dadurch gekennzeichnet**, daß die genannten Leiter (16) die Form von Bändern besitzen, deren Dicke zwischen 50 und 200 Mikron liegt.

## Claims

1. A diode laser device including:
- a heat diffusing substrate (1) made from a material that is a good conductor of heat, in one face of which is formed a system of parallel ribs (2) and grooves (3), said ribs (2) being identical and equidistant, and
- a plurality of semiconductor arrays (12 to 15-22, 23-26 to 29) incorporating said diodes and housed longitudinally in said grooves (3),
**characterized in that** said grooves (2) have an at least approximately triangular cross-section joined to said substrate (1) by one side and each semiconductor array is fixed flat to an oblique flank (7, 8) of one of said ribs (2).

2. The device according to claim 1 **characterized in that** said two oblique flanks (7, 8) of each rib (2) form between them a dihedral angle (a) at least approximately equal to the divergence angle of said laser diodes.

3. The device according to claim 2 **characterized in that** said dihedral angle (a) is in the order of 60°.

4. The device according to any of claims 1 to 3 **characterized in that** said system of parallel ribs (2) and grooves (3) is coated with a metalization film (10) to which said semiconductor arrays are fixed flat and said metalization film (10) includes interruption strips (11, 21) parallel to said ribs (2) and grooves (3).

5. A device acccrding to claim 4 including a film (9) of a material that conducts heat but does not conduct electricity between said system of ribs (2) and grooves (3) and said metalization film (10).

6. The device according to either claim 4 or claim 5 **characterized in that**:
- two semiconductor arrays (12, 13 or 14, 15) are disposed in each groove (3), fixed flat to the facing divergent oblique flanks (7, 8) of said groove (3),
- said semiconductor arrays have the same type of conductivity,
- the interruption strips (11) of the metalization film (10) are in vertical alignment with apexes (5) of said ribs (2),
- in each groove (3), a first conductor (16) electrically connects to each other the two semiconductor arrays, and
- second conductors (18) connect, each time, the first conductor (16) of one groove (3) to the part of the metalization film (10) in the adjacent groove (3).

7. The device according to either claim 4 or claim 5 **characterized in that**:
- a single semiconductor array (22, 23) is disposed in each groove (3) so that all the semiconductor arrays of the device are fixed flat to parallel oblique flanks (8),
- the semiconductor arrays have the same type of conductivity,
- the interruption strips (21) of the metalization film (10) are in vertical alignment with the bases (6) of said grooves (3), and
- in each groove (3), a conductor (16) electrically connects the semiconductor array therein to the part of the metalization film covering the oblique flank (7) opposite the oblique flank (8) to which said semiconductor array is fixed.

8. The device according to either claim 4 or claim 5, **characterized in that**:
- two semiconductor arrays (26, 27 or 28, 29) are disposed in each groove (3), fixed flat to the divergent oblique flanks delimiting said groove (3),
- the two semiconductor arrays in a groove (3) have opposite types of conductivity and all the semiconductor arrays having one type of conductivity are fixed to parallel oblique flanks,
- the interruption strips (21) of the metalization film (10) are in vertical alignment with the bases (6) of said grooves (3), and
- in each groove (3), a conductor (16) connects to each other the two semiconductor arrays having opposite conductivity types.

9. The device according to any of claims 4 to 8 **characterized in that** the thickness of the metalization film (10) is between 50 µm and 200 µm.

10. The device according to any of claims 6 to 9 **characterized in that** said conductors (16) are in the form of strips the thickness of which is between 50 µm and 200 µm.
